# EUROPEAN PATENT APPLICATION

(11) **EP 3 995 896 A1**
(43) Date of publication of application: **11.05.2022**
(21) Application number: 20206671.8
(22) Date of filing: 10.11.2020
(51) Int. Cl.: G03F 7/20, G02B 7/18

(54) **CONDITIONING APPARATUS AND METHOD**

(71) Applicant: ASML Netherlands B.V., 5500 AH Veldhoven (NL)
(72) Inventor: VAN DER NET, Antonius Johannus, 5500 AH Veldhoven (NL); VERHAGEN, Martinus Cornelis Maria, 5500 AH Veldhoven (NL); JACOBS, Johannes Henricus Wilhelmus, 5500 AH Veldhoven (NL); VAN BOKHOVEN, Laurentius Johannes Adrianus, 5500 AH Veldhoven (NL); VAN LIPZIG, Jeroen Peterus Johannes, 5500 AH Veldhoven (NL)
(74) Representative: ASML Netherlands B.V.

(57) **Abstract**

There is provided a conditioning system for a lithographic apparatus, said conditioning system being configured to condition one or more optical elements of the lithographic apparatus, wherein the conditioning system is configured to have a sub-atmospheric pressure at the one or more optical elements. Also provided are a lithographic apparatus comprising such a conditioning system, the use of such a conditioning system, a method of conditioning a system, as well as a lithographic method comprising a sub-atmospheric pressure cooling system

## Description

The present invention relates to a conditioning apparatus for a lithographic apparatus, an assembly for a lithographic apparatus comprising such conditioning apparatus, the use of a sub-atmospheric pressure conditioning apparatus in a lithographic apparatus and a method of conditioning a system or sub-system of a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may for example project a pattern from a patterning device (e.g. a mask) onto a layer of radiation-sensitive material (resist) provided on a substrate.

The wavelength of radiation used by a lithographic apparatus to project a pattern onto a substrate determines the minimum size of features which can be formed on that substrate. A lithographic apparatus which uses EUV radiation, being electromagnetic radiation having a wavelength within the range 4-20 nm, may be used to form smaller features on a substrate than a conventional lithographic apparatus (which may for example use electromagnetic radiation with a wavelength of 193 nm).

Collecting EUV radiation into a beam, directing it onto a patterning device (e.g. a mask) and projecting the patterned beam onto a substrate is difficult because it is not possible to make a refractive optical element for EUV radiation. Therefore, these functions have to be performed using reflectors (i.e. mirrors). Even constructing a reflector for EUV radiation is difficult. The best available normal incidence reflector for EUV radiation is a multi-layer reflector (also known as a distributed Bragg reflector) which comprises a large number of layers which alternate between a relatively high refractive index layer and a relatively low refractive index layer. Each period, consisting of a high refractive index layer and a low refractive index layer, has a thickness equal to half the wavelength (λ/2) of the radiation to be reflected so that there is constructive interference between the radiation reflected at the high to low refractive index boundaries. Such a multilayer reflector still does not achieve a particularly high reflectivity and a substantial proportion of the incident radiation is absorbed by the multilayer reflector.

The absorbed radiation, including infra-red radiation also emitted by the radiation source, can cause the temperature of the multilayer reflector to rise. Known multilayer reflectors are formed on substrates made of materials having a very low coefficient of thermal expansivity, for example ULE^{™}. However, in some cases the cross-section of the beam when incident on a reflector may be small enough that localized heating of the reflector causes undesirable deformation of the surface figure of the reflector. Such deformation can cause imaging errors and the constant desire to image ever smaller features means that the amount of deformation that can be tolerated will only reduce.

Existing reflectors in the projection systems of lithographic apparatuses, particularly EUV apparatuses, are cooled passively, i.e. by radiation, conduction, and convection. However, none of these modes of cooling allows a high rate of heat transfer. In particular, the reflectors are generally in a high vacuum or a low pressure of hydrogen so that heat transfer by convection is minimal. Active cooling of reflectors has been avoided because of the risk of introducing vibrations in the reflector which could easily be more problematic than the distortion caused by the localized heat rise.

WO2017/153152 describes a reflector for EUV radiation, the reflector comprising a reflector substrate and a reflective surface, the reflector substrate having a plurality of coolant channels formed therein, the coolant channels being substantially straight, substantially parallel to each other and substantially parallel to the reflective surface, and are configured so that coolant flows in parallel through the coolant channels and in contact with the reflector substrate. By providing straight coolant channels parallel to one another and parallel to the reflective surface, coolant can be circulated to control the localised temperature without generating problematic vibrations in the reflector.

The present invention has been devised to provide an improved or alternative conditioning system for lithographic apparatus.

### SUMMARY OF THE INVENTION

According to a first aspect of the present invention, there is provided a conditioning system for a lithographic apparatus, said conditioning system being configured to condition one or more optical elements of the lithographic apparatus, wherein the conditioning system is configured to have a sub-atmospheric pressure at the one or more optical elements.

Water conditioning systems may be used to condition modules. In this context, conditioning covers the addition or removal of thermal energy from a module. As such, cooling refers to the removal of thermal energy, and not necessarily a drop in temperature. Similarly, heating refers to the addition of thermal energy, and not necessarily a drop in temperature. It will be appreciated that it is desirable for the operating temperature of any optical elements to be kept as constant as possible or at least within a controlled temperature range. Whilst the present application will focus on and make primary reference to cooling, it should also be appreciated that in some cases, the system may be used to heat a module or sub-module of a lithographic apparatus. Conditioning systems usually comprise a thermal control, such as a heat exchanger, a heater, and/or a cooler, and optionally a temperature sensor. Such systems also usually comprise a water bath or reservoir that is open to the atmosphere or pressurized, a pump to deliver water flow, and a distribution system, which usually includes pipes, manifolds, and the like. The systems are designed to handle and to operate at water pressures of around 3 to 8 barg. Whilst higher pressures could be used, there are additional safety requirements for systems operating in excess of around 10 barg, so are generally less preferred. However, pressure differences can result in mechanical stress and deformation, although these are generally not a problem as the exact shape of a component has little, if any, impact upon the operation of an apparatus. However, optical elements of a lithographic apparatus, particularly an EUV lithographic apparatus, are very sensitive to any deformations, even very small ones.

It has been found that if the relative pressure between the conditioning system and the outside of the optical element is greater than atmospheric pressure, there will be deformation of the surface of the optical elements and this deformation impacts the performance of the optical elements. Since the conditioning system is for a lithographic apparatus, the main parts of the lithographic apparatus that are to be conditioned, whether by cooling or heating, are under vacuum or only a very low pressure of gas, usually hydrogen, and so it has been found that sub-atmospheric pressures are desired to avoid deformation of critical components with the associated loss of performance. Whilst it has previously been mitigated by providing the condition channels deeper within the substrate of the system being conditioned, this impacts on thermal performance and the conditioning provided is insufficient in cases where the conditioning channels need to be deep within a substrate in order to reduce or eliminate deformation. By providing a conditioning system which is configured to operate at sub-atmospheric pressure at the one or more optical elements, i.e. have a sub-atmospheric pressure operating pressure, the deformation of the surface of the optical element being conditioned is eliminated or at least reduced to acceptable levels, and it is possible for the conditioning fluid to be provided in channels which are not as deep in the substrate meaning that thermal efficiency is improved. In the context of the present application a sub-atmospheric pressure is one which is less than 1 bara.

The conditioning system is configured to condition one or more optical elements of the lithographic apparatus. One or more of the optical elements may be a reflector. The conditioning may also be referred to as thermal conditioning. In order to condition an optical element, the conditioning system needs to be in thermal communication with the optical element or elements of the lithographic apparatus. The optical elements are therefore provided with conditioning fluid channels which are configured to allow conditioning fluid the flow therethrough. In the present invention, the pressure within such conditioning fluid channels are sub-atmospheric, i.e. less than 1 bara. In use, the optical elements, amongst other units of the lithographic apparatus, will increase in temperature unless they are cooled. This is because the optical elements are exposed to the radiation used in the lithographic process, part of which is absorbed resulting in a temperature increase. If the optical elements are not cooled, they will heat up and performance will be adversely affected. As operating powers of lithographic apparatuses increase, it is necessary to similarly increase the conditioning capacity of such apparatuses, particularly the cooling capacity. In other cases, it may be necessary to provide thermal energy to a component of a lithographic apparatus to bring them up to the desired operating temperature.

The conditioning system may be configured to operate at between around 0.02 bara and around 0.9 bara. The system preferably operates at a minimum pressure of not less than 0.02 bara. The system may operate at around 0.2 bara to around 0.8 bara. The system may operate at around 0.1 bara, around 0.2 bara, around 0.3 bara, around 0.4 bara, around 0.5 bara, around 0.6 bara, around 0.7 bara, around 0.8 bar, or around 0.9 bara. It has been found that around 0.3 bara is a particularly suitable operating pressure. As mentioned above, by operating at below atmospheric pressure (1 bara), it is possible to avoid the problems associated with deformation caused by using pressure above 1 bara and also allows any conditioning channels to be provided closer to the surface which is to be conditioned than would otherwise be the case, thereby improving conditioning efficiency. Of course, if the pressure is too low, then there is a risk of cavitation and there would not be enough pressure difference to cause conditioning fluid to flow. In addition, if the system goes below the vapour pressure of the conditioning fluid, which may be water, the conditioning fluid may boil at an undesirably low temperature, for example 22°C at 0.02 bara for water. It has been found that operating pressures of between around 0.02 bara and 0.9 bara provide the correct balance between avoiding deformation, avoiding cavitation, allowing conditioning fluid channels to be close enough to the surface to be conditioned efficiently, and allowing conditioning fluid flow through the system. The conditioning system of the present invention also allows in some cases the avoidance of the need to manufacture optical elements, such as reflectors, when under pressure. It will be appreciated that at certain points in the conditioning system, the pressure may be around atmospheric or even slightly above atmospheric. Even so, the system is configured such that the pressure at the optical element or elements being conditioned is sub-atmospheric when in use. Since the optical elements are in a very low pressure environment within the lithographic apparatus of around a few pascals of hydrogen, the pressure differential between the conditioning fluid channels within the optical element and the outside of the optical element is effectively equal to the pressure of the conditioning fluid within the conditioning fluid channels.

The conditioning system may include a liquid conditioning fluid, preferably water. The conditioning fluid may be provided with one or more additives to improve performance, such as corrosion inhibitors to prevent corrosion within the system. Whilst conditioning fluids such as carbon dioxide may be used in other systems, this usually requires much higher pressures in order to obtain the necessary mass flow to provide effective conditioning and so there are additional safety considerations to take into account and the high pressures required, such as from 20 to 100 bar, are not compatible with avoiding deformation. Whilst other water-cooled systems may describe a broad range of pressures, there is no realization of the suitability of the specific range described herein, nor of operating at sub-atmospheric pressures at the units which are being conditioned, namely at the optical elements. Pressures above atmospheric pressure have previously been used since these can be more readily achieved by the provision of standard pumping apparatus, which pressurizes water to above atmospheric pressure in order to pump the water through the conditioning system, and the problem of deformation has been addressed by modifying the configuration of the conditioning channels. Water is preferred due to its safety, high thermal mass, and availability.

The system may include a conditioning fluid reservoir. The conditioning fluid reservoir may be at least partially filled with conditioning fluid, preferably water. By having a conditioning fluid reservoir, there is a thermal mass of conditioning fluid which can be circulated through the system to remove heat therefrom or add heat thereto.

The system may include a pump downstream of the optical element and a flow restrictor upstream of the optical element. As such, the suction side of the pump may be in fluid connection with a conditioning channel of the optical element such that when the pump is in operation, a pressure which is below atmospheric pressure is created at the optical element. The presence of the flow restrictor upstream of the optical element ensures that the pressure at the optical element is below atmospheric pressure. The present invention is not particularly limited by the exact dimensions or nature of the flow restrictor since these will depend on the dimensions of the pipes which carry the conditioning fluid, the required flow rate, and the required pressure of the system, but these can be determined routinely by the skilled person and the pressure at the optical element being conditioned can be measured routinely to confirm the pressure therein.

The system may include a sub-atmospheric pressure conditioning fluid reservoir. As such, the system may comprise a conditioning fluid reservoir which is at sub-atmospheric pressure. The sub-atmospheric conditioning fluid reservoir may be connected to a vacuum pump. The vacuum pump may be configured to allow control of the pressure within the conditioning fluid reservoir by removing gases from the reservoir to provide the desired sub-atmospheric pressure. A gas inlet may optionally be provided which allows a gas, such as air or nitrogen, to be introduced into the conditioning fluid reservoir to increase the pressure should it become too low. The system may include a controller which is operable to control the vacuum pump and/or gas inlet in order to achieve the desired sub-atmospheric pressure.

In some embodiments which include a sub-atmospheric conditioning fluid reservoir, a pump is provided downstream of the optical element and a flow restrictor is provided upstream of the optical element. In other embodiments including a sub-atmospheric pressure conditioning fluid reservoir, the pump may be provided upstream of the optical element since the downstream portion of the conditioning system is connected to the sub-atmospheric conditioning fluid reservoir and therefore the pressure at the optical element is able to remain sub-atmospheric. Optionally, a flow restrictor is provided upstream of the pump and downstream of the optical element, namely between the pump and the optical element, in order to control the flow of conditioning fluid and avoid the pressure at the optical element from exceeding atmospheric pressure.

The sub-atmospheric pressure conditioning fluid reservoir may include a deformable separator between the liquid conditioning fluid and a gas. The deformable separator may be in the form of a membrane. By having a deformable separator between the conditioning fluid and a gas within the sub-atmospheric pressure conditioning fluid reservoir, the sub-atmospheric pressure can be maintained without any evaporation of the conditioning fluid. The gas above the deformable separator may have its pressure adjusted to control the pressure within the system. The composition of the gas is not particularly limiting on the present invention, and may, for example, be air or nitrogen. The pressure of the gas can be adjusted to adjust the pressure within the system. In addition, the separator is able to be deformed to take account of any pressure changes and to also act as a vibration damper.

The conditioning system may include one or more vibration dampers, which may serve to dampen pressure control error or flow induced vibrations. The one or more vibration dampers may be in the form of one or more hydraulic accumulators. As the optical elements are also very sensitive to vibrations, it is desirable to reduce or eliminate vibrations where possible. By providing one or more vibration dampers, which may be in the form of one or more hydraulic accumulators, any vibrations can be reduced.

In embodiments, a or the conditioning fluid reservoir may be disposed below the optical element such that the hydrostatic pressure difference between the optical element and the conditioning fluid reservoir reduces the pressure present at the optical element to below atmospheric pressure. As such, if the conditioning fluid reservoir is provided below the height of the return side of the optical element, the hydrostatic pressure difference is sufficient to reduce the pressure of the conditioning fluid at the optical element to below atmospheric pressure. A pump may be provided to supply conditioning fluid to the optical element and the pressure being over atmospheric pressure is avoided by the hydrostatic pressure difference. There may be a pressure control device between the optical element and the conditioning fluid reservoir. The pressure control device may be configured to control the flow of conditioning fluid therethrough in order to control the pressure at the optical element. Optionally, there may be provided a pressure sensor configured to control the pressure control device. A pressure controller may be provided which receives an input from a pressure sensor and is operable to control the pump and/or a gas inlet flow controller.

In embodiments, the system may comprise first and second conditioning fluid reservoirs. The first and second conditioning fluid reservoirs may be in fluid communication with one another via a valve. The valve may be operable to control the level of conditioning fluid in the coolant reservoir which is in fluid communication with the optical element to control the pressure. In an embodiment, the level of conditioning fluid in the conditioning fluid reservoir, and therefore the static pressure on the optical element, may be controlled by the provision of a conditioning fluid overflow in which the height of the conditioning fluid overflow is related to the height of the optical element.

According to a second aspect of the present invention, there is provided a lithographic apparatus comprising a conditioning system according to the first aspect of the present invention. The lithographic apparatus may be an EUV lithographic apparatus.

According to a third aspect of the present invention, there is provided the use of a sub-atmospheric pressure conditioning system in a lithographic apparatus. Preferably, the conditioning system is a conditioning system according to the first aspect of the present invention.

According to a fourth aspect of the present invention, there is provided a method of conditioning a system or sub-system of a lithographic apparatus, wherein said method includes providing a liquid conditioning fluid at sub-atmospheric pressure to the system or sub-system to be conditioned. The system or sub-system may comprise an optical element, such as, for example a reflector or mirror. There may be one or more than one optical elements. Suitable distribution means, such as pipes and manifolds may be provided, to allow the conditioning fluid to be provided to the optical elements.

According to a fifth aspect of the present invention, there is provided a lithographic method comprising projecting a patterned beam of radiation onto a substrate, wherein the patterned beam is directed or patterned using at least one optical element comprising a conditioning system according to any aspect of the present invention.

It will be appreciated that features described in respect of one aspect or embodiment may be combined with any features described in respect of another aspect or embodiment and all such combinations are expressly considered and disclosed herein.

### BRIEF DESCRIPTION OF THE DRAWINGS

Embodiments of the invention will now be described, by way of example only, with reference to the accompanying schematic drawings in which corresponding reference symbols indicate corresponding parts, and in which:
Figure 1 depicts a lithographic apparatus according to an embodiment of the invention;
Figure 2 depicts a first embodiment of a system according to the present invention;
Figure 3 depicts a second embodiment of a system according to the present invention;
Figure 4 depicts a third embodiment of a system according to the present invention;
Figure 5 depicts a fourth embodiment of a system according to the present invention;
Figure 6 depicts a fifth embodiment of a system according to the present invention;
Figure 7 depicts a sixth embodiment of a system according to the present invention; and
Figure 8 depicts a seventh embodiment of a system according to the present invention.

The features and advantages of the present invention will become more apparent from the detailed description set forth below when taken in conjunction with the drawings, in which like reference characters identify corresponding elements throughout. In the drawings, like reference numbers generally indicate identical, functionally similar, and/or structurally similar elements.

### DETAILED DESCRIPTION

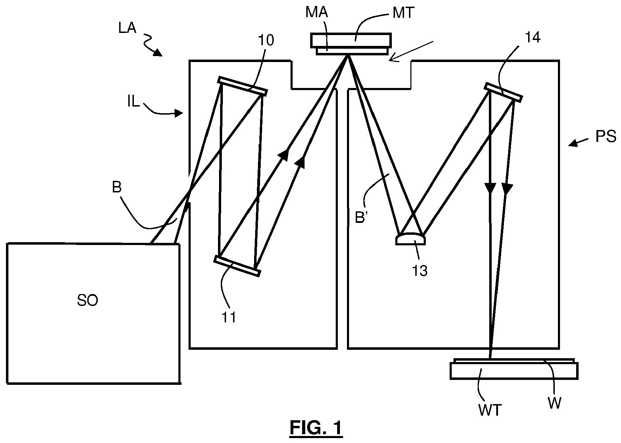

Figure 1 shows a lithographic according to an embodiment of the present invention. The lithographic system comprises a radiation source SO and a lithographic apparatus LA. The radiation source SO is configured to generate an extreme ultraviolet (EUV) radiation beam B. The lithographic apparatus LA comprises an illumination system IL, a support structure MT configured to support a patterning device MA (e.g. a mask), a projection system PS and a substrate table WT configured to support a substrate W. The illumination system IL is configured to condition the radiation beam B before it is incident upon the patterning device MA. The projection system is configured to project the radiation beam B (now patterned by the mask MA) onto the substrate W. The substrate W may include previously formed patterns. Where this is the case, the lithographic apparatus aligns the patterned radiation beam B with a pattern previously formed on the substrate W.

The radiation source SO, illumination system IL, and projection system PS may all be constructed and arranged such that they can be isolated from the external environment. A gas at a pressure below atmospheric pressure (e.g. hydrogen) may be provided in the radiation source SO. A vacuum may be provided in illumination system IL and/or the projection system PS. A small amount of gas (e.g. hydrogen) at a pressure well below atmospheric pressure may be provided in the illumination system IL and/or the projection system PS.

The radiation source SO shown in Figure 1 is of a type which may be referred to as a laser produced plasma (LPP) source. A laser, which may for example be a CO₂ laser, is arranged to deposit energy via a laser beam into a fuel, such as tin (Sn) which is provided from a fuel emitter. Although tin is referred to in the following description, any suitable fuel may be used. The fuel may for example be in liquid form, and may for example be a metal or alloy. The fuel emitter may comprise a nozzle configured to direct tin, e.g. in the form of droplets, along a trajectory towards a plasma formation region. The laser beam is incident upon the tin at the plasma formation region. The deposition of laser energy into the tin creates a plasma at the plasma formation region. Radiation, including EUV radiation, is emitted from the plasma during de-excitation and recombination of ions of the plasma.

The EUV radiation is collected and focused by a near normal incidence radiation collector (sometimes referred to more generally as a normal incidence radiation collector). The collector may have a multilayer structure which is arranged to reflect EUV radiation (e.g. EUV radiation having a desired wavelength such as 13.5 nm). The collector may have an elliptical configuration, having two ellipse focal points. A first focal point may be at the plasma formation region, and a second focal point may be at an intermediate focus, as discussed below.

The laser may be separated from the radiation source SO. Where this is the case, the laser beam may be passed from the laser to the radiation source SO with the aid of a beam delivery system (not shown) comprising, for example, suitable directing mirrors and/or a beam expander, and/or other optics. The laser and the radiation source SO may together be considered to be a radiation system.

Radiation that is reflected by the collector forms a radiation beam B. The radiation beam B is focused at a point to form an image of the plasma formation region, which acts as a virtual radiation source for the illumination system IL. The point at which the radiation beam B is focused may be referred to as the intermediate focus. The radiation source SO is arranged such that the intermediate focus is located at or near to an opening in an enclosing structure of the radiation source.

The radiation beam B passes from the radiation source SO into the illumination system IL, which is configured to condition the radiation beam. The illumination system IL may include a facetted field mirror device 10 and a facetted pupil mirror device 11. The faceted field mirror device 10 and faceted pupil mirror device 11 together provide the radiation beam B with a desired cross-sectional shape and a desired angular distribution. The radiation beam B passes from the illumination system IL and is incident upon the patterning device MA held by the support structure MT. The patterning device MA reflects and patterns the radiation beam B. The illumination system IL may include other mirrors or devices in addition to or instead of the faceted field mirror device 10 and faceted pupil mirror device 11.

Following reflection from the patterning device MA the patterned radiation beam B enters the projection system PS. The projection system comprises a plurality of mirrors 13, 14 which are configured to project the radiation beam B onto a substrate W held by the substrate table WT. The projection system PS may apply a reduction factor to the radiation beam, forming an image with features that are smaller than corresponding features on the patterning device MA. A reduction factor of 4 may for example be applied. Although the projection system PS has two mirrors 13, 14 in Figure 1, the projection system may include any number of mirrors (e.g. six mirrors).

In use the optical elements of the lithographic apparatus, such as mirrors or reflectors, are heated by the radiation and it is therefore necessary to condition such optical elements. As such, a conditioning system according to the present invention is integrated into the lithographic apparatus to provide the required conditioning. Conditioning usually requires the removal of thermal energy from the optical elements as they heat up during use.

The radiation sources SO shown in Figure 1 may include components which are not illustrated. For example, a spectral filter may be provided in the radiation source. The spectral filter may be substantially transmissive for EUV radiation but substantially blocking for other wavelengths of radiation such as infrared radiation.

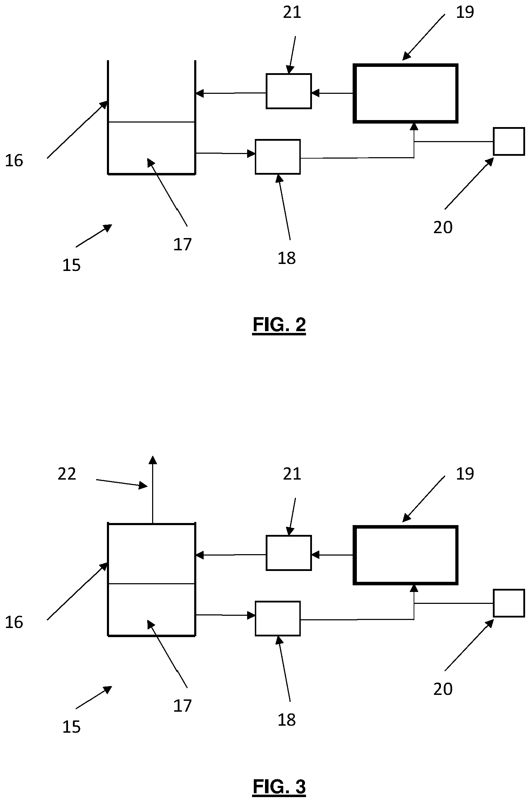

Figures 2 to 8 are schematic depictions of conditioning systems according to the present invention.

Figure 2 depicts an embodiment of a conditioning system 15 in accordance with a first embodiment of the present invention. The conditioning system 15 includes a conditioning fluid reservoir 16. In the depicted example, the top of the conditioning fluid reservoir 16 is shown as being open. Whilst in practice, the conditioning fluid reservoir may or may not be open, it is depicted as being open to demonstrate that the conditioning fluid 17 therein, which may be water, is not pressurized above atmospheric pressure and may be at ambient pressure. The conditioning fluid reservoir 17 is connected to an optical element 19 via optional flow restrictor 18. An optional pressure sensor 20 may be provided to measure the pressure of the conditioning fluid as it enters the optical element 19 or inside the optical element 19. A pump 21 is connected between the optical element 19 and the conditioning fluid reservoir 16. In use, conditioning fluid 17 from the conditioning fluid reservoir 16 (which may also be referred to as a conditioning fluid vessel or container) passes into an optical element 19 via the pressure difference between reservoir outlet and the pump inlet, created by the pump. In other embodiments, the flow relies on gravity based on the relative position of the tank and optical element. A pump 21 connected to an output side of the optical element 19 pumps the conditioning fluid 17 back to the conditioning fluid reservoir 16 where it is able to subsequently be recirculated through the conditioning system 15. The flow restrictor 18 can be of any suitable design and the present invention is not particularly limited by the exact nature of the flow restrictor. The flow restrictor 18 functions to provide the required pressure drop at the optical element 19 such that the conditioning fluid at or within the optical element 19 is below atmospheric pressure. In any of the depicted embodiments, the optical element 19 which is being conditioned contains at least one channel through which conditioning fluid may pass in order to absorb heat from or provide heat to the optical element 19 and transport it away thereby conditioning the optical element 19. The level of the conditioning fluid 17 in the conditioning fluid reservoir 16 is schematic only and may be above or below the point at which conditioning fluid 17 is returned via pump 21.

Figure 3 depicts a similar conditioning system as Figure 2 albeit with the difference that the conditioning fluid reservoir 16 is not at atmospheric pressure. Instead, the system is sealed such that it is taken down to the desired sub-atmospheric pressure and then closed off so that it remains at sub-atmospheric pressure. A gas connection 22 may be provided which is able to reduce the pressure within the system should it increase above desired levels. Similarly, additional gas or conditioning fluid may be added to the system if the pressure falls too much or more conditioning fluid is required.

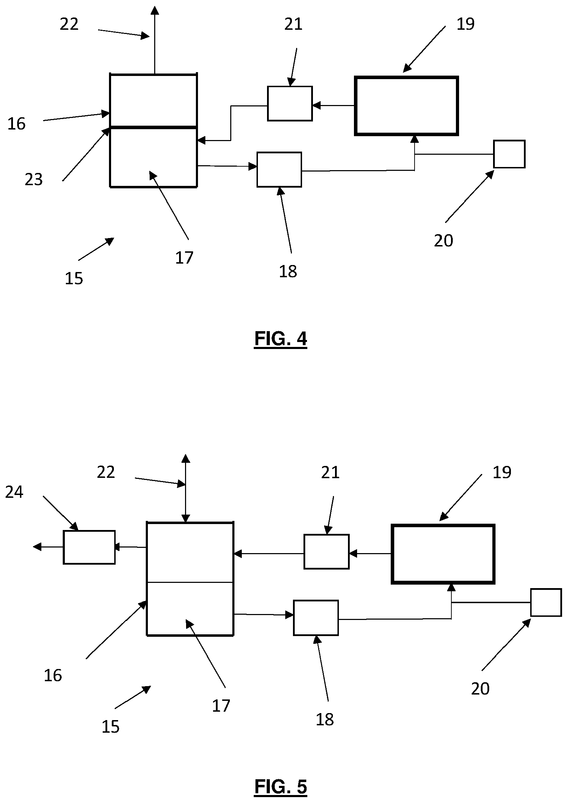

Figure 4 depicts a similar conditioning system to Figure 3 albeit with a deformable separator 23, which may be in the form of a membrane, which separates the conditioning fluid 17 from the gas above it within the conditioning fluid reservoir 16. The separator 23 prevents evaporation of any of the conditioning fluid and therefore avoids the loss of conditioning fluid and also avoids the need to have a vacuum pump or controlled gas inlet. The separator 23 also dampens flow induced vibration within the system.

Figure 5 depicts a further embodiment of a conditioning system 15 in accordance with the present invention. This embodiment is similar to that of Figure 2 albeit having a closed system and having a sub-atmospheric pressure conditioning fluid reservoir 16. The conditioning fluid reservoir 16 is maintained at below atmospheric pressure by vacuum pump 24. Vacuum pump 24 is configured to reduce the pressure within the system by removing gas present therein. A controlled gas inlet may be provided which can add or remove gas from the system as required.

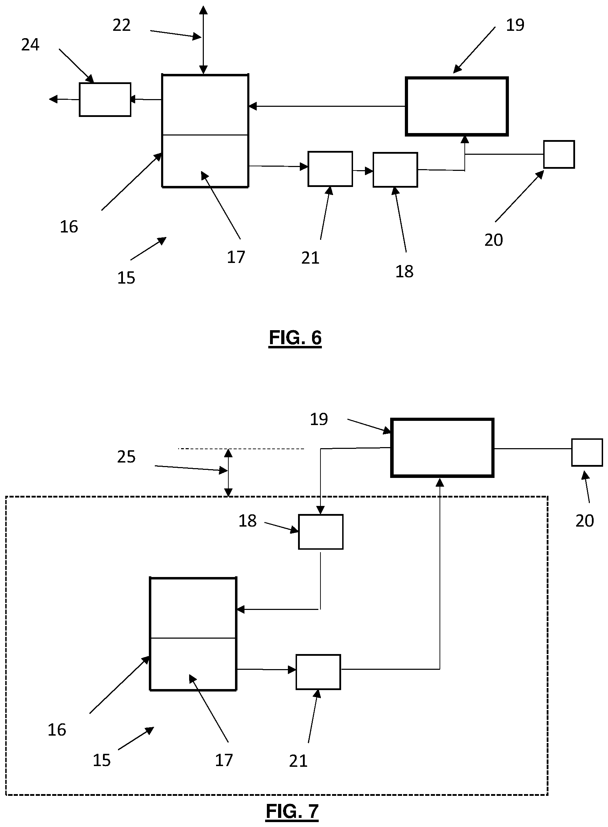

Figure 6 depicts an embodiment which is similar to that of Figure 5 albeit the pump 21 which is used to move the conditioning fluid through the system is disposed between the conditioning fluid reservoir 16 and the inlet of the optical element 19. In this embodiment, conditioning fluid 17 is pumped by pump 21 via restrictor 18 into the optical element 19. The outlet of the optical element 19 is fluidly connected to the sub-atmospheric pressure conditioning fluid reservoir 16. Vacuum pump 24 and gas connector 22 are operable to remove and introduce gas as appropriate in order to control the pressure within the system.

Figure 7 depicts yet another embodiment of a conditioning system according to the present invention. In this embodiment, the low pressure is generated by utilizing the hydrostatic pressure difference 25 caused by the conditioning fluid reservoir 16 being located at a lower height than the optical element 19. The hydrostatic pressure difference 25 causes a reduced pressure on the return side of the optical element 19. The pump 21 compensates for this and is able to provide conditioning fluid to the supply side of the optical element 19. The dotted box surrounding the conditioning fluid reservoir 16, the pump 21, and the flow restrictor 18 indicates that these elements are located below the optical element and that the exact positioning of such elements relative to the optical element 19 is schematic only. It will be appreciated that the flow restrictor 18 may be provided adjacent the return side of the optical element 19.

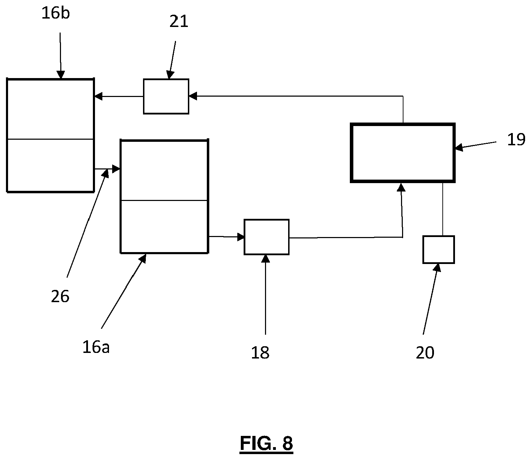

Figure 8 depicts yet another embodiment of a conditioning system according to the present invention. In this embodiment, there are two conditioning fluid reservoirs 16a, 16b. The two conditioning fluid reservoirs 16a, 16b are connected via a valve 26 which is operable to control the water level within conditioning fluid reservoir 16a. This in turn controls the hydrostatic pressure of the conditioning fluid which is provided to the optical element 19 in combination with the water pump 21 which is connected to the return side of the optical element.

In summary, the present invention provides for a sub-atmospheric conditioning system which enables the conditioning of critical components of a lithographic apparatus and enables such components directly and therefore increases thermal efficiency and enables improved performance at higher thermal loads without causing unwanted deformation of the optical elements. The present invention has particular, but not exclusive application, to the cooling of optical element of lithographic apparatuses.

While specific embodiments of the invention have been described above, it will be appreciated that the invention may be practiced otherwise than as described.

The descriptions above are intended to be illustrative, not limiting. Thus it will be apparent to one skilled in the art that modifications may be made to the invention as described without departing from the scope of the claims set out below.

## Claims

1. A conditioning system for a lithographic apparatus, said conditioning system being configured to condition one or more optical elements of the lithographic apparatus, wherein the conditioning system is configured to have a sub-atmospheric pressure at the one or more optical elements.

2. The conditioning system according to claim 1, wherein at least one of the optical elements is a reflector or a mirror.

3. The conditioning system according to claim 1 or claim 2, wherein the conditioning system is configured to operate at between around 0.02 and 0.9 bara, preferably around 0.3 bara.

4. The conditioning system according to any of claims 1 to 3, wherein the conditioning system includes a liquid conditioning fluid, preferably wherein the liquid conditioning fluid is water.

5. The conditioning system according to any of claims 1 to 4, wherein the system includes a conditioning fluid reservoir.

6. The conditioning system according to any of claims 1 to 5, wherein the system includes a pump downstream of the optical element and a flow restrictor upstream of the optical element.

7. The conditioning system according to any of claims 1 to 6, wherein the system includes a sub-atmospheric pressure conditioning fluid reservoir.

8. The conditioning system according to claim 7, wherein the sub-atmospheric pressure conditioning fluid reservoir is connected to a vacuum pump and/or a gas inlet.

9. The conditioning system according to any of claims 1 to 5 and 7 to 8 when not dependent on claim 6, wherein the system includes a pump upstream of the optical element, and optionally a flow restrictor between the pump and the optical element.

10. The conditioning system according to any of claims 7 to 9, wherein the sub-atmospheric pressure conditioning fluid reservoir includes a deformable separator, preferably wherein the deformable separator is disposed between the liquid conditioning fluid and a gas.

11. The conditioning system according to any preceding claim, wherein said conditioning system further includes one or more vibration dampers, optionally wherein the one or more vibration dampers are in the form of one or more hydraulic accumulators.

12. The conditioning system according to any of claims 9 to 11 when not dependent on claim 6, wherein a or the conditioning fluid reservoir is disposed below the optical element such that the hydrostatic pressure difference between the optical element and the conditioning fluid reservoir reduces the pressure at the optical element to below atmospheric pressure.

13. The conditioning system according to any preceding claim, wherein the system comprises first and second conditioning fluid reservoirs, wherein the first and second conditioning fluid reservoirs are in fluid connection with one another via a valve which is operable to control the level of conditioning fluid in the conditioning fluid reservoir which is in fluid communication with the optical element.

14. A lithographic apparatus comprising the conditioning system according to any of claims 1 to 13.

15. The use of a sub-atmospheric pressure conditioning system in a lithographic apparatus, preferably wherein the conditioning system is a conditioning system according to any of claims 1 to 13.

16. A method of conditioning a system or sub-system of a lithographic apparatus, said method including providing a liquid conditioning fluid at sub-atmospheric pressure to the system or sub-system to be conditioned.

17. The method according to claim 16, wherein the system or sub-system comprises an optical element, optionally wherein the optical element is a reflector or mirror.

18. A lithographic method comprising projecting a patterned beam of radiation onto a substrate, wherein the patterned beam is directed or patterned using at least one optical element comprising a conditioning system according to any of claims 1 to 13 or conditioned according to a method of claims 16 or 17.
